# EUROPÄISCHE PATENTANMELDUNG

(11) **EP 4 465 130 A2**
(43) Veröffentlichungstag der Anmeldung: **20.11.2024**
(21) Anmeldenummer: 24163101.9
(22) Anmeldetag: 13.03.2024
(51) Int. Cl.: G03F 7/00, G03F 7/20

(54) **ANLAGE UND VERFAHREN ZUR HERSTELLUNG VON FLEXO DRUCKFORMEN**

(30) Priorität: 16.05.2023 DE 102023112826
(71) Anmelder: Neuefeind GmbH, 56299 Ochtendung (DE)
(72) Erfinder: Neuefeind, Sven, 56299 Ochtendung (DE)
(74) Vertreter: Hannke, Christian

(57) **Zusammenfassung**

Die vorliegende Erfindung betrifft eine Anlage und ein Verfahren zur Herstellung von Druckformen für Flexo Druck, umfassend eine Trägerplatte an einer Haltevorrichtung, ein Becken und eine Belichtungsanlage. Hierbei wird auf eine Trägerplatte ein verfestigbares Medium in Bereichen oder punktuell in mindestens einer Schicht aufgetragen, um eine erhabene Oberfläche der Druckform zu gestalten. Hierbei werden mit mindestens einer Belichtungsanlage, die UV- Strahlung emittiert, Stellen, die dieser ausgesetzt sind, verfestigt. Durch die Sequenz aus Belichten über eine definierte Zeit und anschließendes Verfahren der Trägerplatte vorzugsweise in vertikaler Richtung zur Belichtungsanlage wird Schicht um Schicht des verfestigbaren Mediums verfestigt. So entsteht durch Wiederholung dieser Sequenz eine erhabene Druckform.

## Beschreibung

Die vorliegende Erfindung betrifft eine Anlage und ein Verfahren zur Herstellung von Druckformen für Flexo Druck, umfassend eine Trägerplatte an einer Haltevorrichtung, ein Becken und eine Belichtungsanlage. Hierbei wird auf eine Trägerplatte ein verfestigbares Medium in Bereichen oder punktuell in mindestens einer Schicht aufgetragen, um eine erhabene Oberfläche der Druckform zu gestalten. Hierbei werden mit mindestens einer Belichtungsanlage, die UV- Strahlung emittiert, Stellen, die dieser ausgesetzt sind, verfestigt. Durch die Sequenz aus Belichten über eine definierte Zeit und anschließendes Verfahren der Trägerplatte vorzugsweise in vertikaler Richtung bezüglich der Belichtungsanlage wird Schicht um Schicht des verfestigbaren Mediums verfestigt. So entsteht durch Wiederholung dieser Sequenz eine erhabene Druckform.

Ein häufiges Anwendungsfeld für Flexo Druckformen ist das Bedrucken von Verpackungen. Hierbei wird die Druckform auf eine Walze gespannt, mit der dann eine meist polare Druckfarbe auf das zu bedruckende Material aufgebracht wird. Um die meist flächig produzierten Druckformen auf Walzen zu befestigen, ist eine weiche und elastische Beschaffenheit der Druckformen unumgänglich. Zudem müssen die Druckformen beständig gegenüber den verwendeten Farben auf Wasser- oder Lösemittelbasis und UV-Farben sein. Ebenso muss die Druckform gegen Verschleiß beim Drucken, der durch das Abrollen der Druckform an dem zu bedruckenden Material entsteht, ausreichend resistent sein.

Die gebräuchlichen Fertigungsmethoden für solche Druckformen sind subtraktive Verfahren, bei denen Material aus einer Matte entnommen wird, um Formen, Muster und/oder Reliefs herzustellen. Diese Verfahren weisen viele notwendige Prozessschritte auf und sind zudem materialintensiv, da das entfernte Material nicht weiterverwendet werden kann. Die Rohlinge sind meist Matten, welche nach heutigem Stand der Technik eine obere UV-undurchlässige Schicht aufweisen, die mit einem Laser entfernt werden kann. Das so entstandene Muster / Relief wird im Anschluss mit UV-Strahlung belichtet. Durch diesen Prozessschritt verfestigt sich das Material an den Stellen, an die UV-Licht gelangt. Die Stellen und Bereiche, die von der UV-undurchlässigen Schicht abgedeckt sind, bleiben weich und verfestigen sich nicht. Natürlich kann die UV-undurchlässige Schicht auch eine Art Folie sein, die auf das Grundmaterial gelegt wird.

Im Anschluss wird die Matte gewaschen. Hierbei werden die weichen, nicht verfestigten Bereiche aus der Matte ausgewaschen - und somit von der Grundmatte subtrahiert. Nur die im vorangegangenen Prozessschritt belichteten Stellen und Flächen bleiben erhaben auf der Matte zurück. Da die Reinigungsflüssigkeit bei diesem Prozessschritt das gelöste unbelichtete Material der Matte aufgenommen hat, ist auch hier ein erhöhter Materialeinsatz vorhanden, da die Waschflüssigkeit oft erneuert werden muss. Im Anschluss sind Trocknen und Finishen der Matte notwendig, bevor sie zugeschnitten werden kann.

Somit weist der Stand der Technik einen erheblichen Aufwand an Material und Zeit auf, da auch meist jeder einzelne Prozessschritt eine andere Anlage, bzw. Maschine benötigt. Zudem kommt zusätzlich die potenzielle Fehlerquelle des Umspannens der Matten auf die jeweilige Anlage, bzw. Maschine hinzu.

Aus WO 2017/068125 ist auch eine additive Fertigungsmethode bekannt. Hierbei wird mit einer Art Drucker eine reaktive Flüssigkeit auf ein Trägermaterial aufgetragen. Dies geschieht in mehreren Lagen. Im Anschluss wird eine Einwirkzeit benötigt, damit die reaktive Flüssigkeit in das Trägermaterial eindiffundieren kann. Erst im Anschluss erfolgt eine Aushärtung des Materials durch z.B. UV-Licht.

Auch der Stand der Technik dieser additiven Fertigungsmethode weist verschiedene Nachteile auf, da zum einen durch einen mehrfachen Auftrag des reaktiven Materials ohne vorhergehendes Aushärten der unteren Lage eine Unschärfe eintritt, je höher die erhabenen Stellen und Formen ausfallen, zum anderen ist die Einwirkzeit für eine effektive Produktion hinderlich. Somit besteht gerade für komplexe und kleine Zeichen, wie QR- oder Barcodes, die derzeit zum Einsatz kommen, die Notwendigkeit einer andersartigen Produktionsmöglichkeit.

Hieraus ergibt sich das Erfordernis für eine neue Anlage und ein neues Verfahren zur Herstellung von Flexo Druckformen, die nur wenige Produktionsschritte erfordert, kostengünstig ist und auch präzise mit hoher Auflösung komplexe Formen und Strukturen auf einer Druckplatte darstellen kann.

Es hat sich gezeigt, dass diese Aufgabenstellung durch eine Anlage nach Anspruch 1 und ein Verfahren nach Anspruch 6 gelöst werden kann.

Die vorliegende Erfindung betrifft eine Anlage und ein Verfahren zur Herstellung von Druckformen für Flexo Druck. Die Anlage umfasst eine Trägerplatte und eine Haltevorrichtung, an welcher die Trägerplatte angeordnet ist, ein Becken und eine Belichtungsanlage. Das Becken ist mit einem verfestigbaren Medium befüllbar und die Trägerplatte ist in dieses eintauchbar. Die Belichtungsanlage kann UV-Strahlung in Mustern, Bilder oder anderen Formen auf das verfestigbare Medium abstrahlen, wobei die Trägerplatte und die Belichtungsanlage so angeordnet sind, dass zumindest eine Schicht des verfestigbaren Mediums zwischen einer Hauptseite der Trägerplatte und der Belichtungsanlage mit UV-Strahlung belichtet werden kann und hierdurch an der Trägerplatte angelagert und verfestigt wird. Die Trägerplatte ist im Becken justierbar und eine Schichtdicke der Schicht des verfestigbaren Mediums zwischen Trägerplatte und Belichtungsanlage ist durch eine Relativbewegung von Trägerplatte und Becken einstellbar.

Bevorzugt ist die Trägerplatte flach ausgeführt. Daher entsprechen Länge und Breite der Trägerplatte einem Vielfachen ihrer Höhe. Die Flächen, die sich durch Länge und Breite ergeben, entsprechen hierbei den Hauptseiten. Die Stirnflächen entsprechen den Produkten aus Plattenhöhe und -breite oder -länge.

Die Hauptseite der Trägerplatte, an der Schichten des verfestigbaren Mediums angelagert werden, weist eine entsprechende Oberflächenbeschaffenheit, bzw. -rauigkeit, auf, so dass die erste Schicht des verfestigbaren Mediums anhaftet. Nach dem Auftrag der Schichten sind diese wieder von der Trägerplatte löslich, ohne die erhabene Struktur aus Schichten des verfestigbaren Mediums und/oder die Trägerplatte zu beschädigen.

Die Trägerplatte ist im Becken justierbar, so dass die Dicke der Schicht des verfestigbaren Mediums zwischen Trägerplatte und Belichtungsanlage durch eine Relativbewegung von Trägerplatte und Becken einstellbar ist. Diese Relativbewegung kann nicht nur durch ein Verfahren der Trägerplatte, sondern alternativ durch ein Verfahren des Beckens erfolgen. Ebenso ist ein kombiniertes Verfahren von Becken und Trägerplatte denkbar.

Gemäß einer bevorzugten Ausführungsform ist die Belichtungsanlage über oder unter dem Becken angeordnet, wobei das Becken einen UV-durchlässigen Beckenboden aufweist, wenn die Belichtungsanlage unter dem Becken angeordnet ist. Durch diesen UV-durchlässigen Beckenboden kann die Belichtungsanlage die UV-Strahlung in Mustern, Bildern oder andere Formen in hoher Auflösung auf den hierfür durchlässigen Boden abstrahlen, wobei die UV-Strahlen durch den UV-durchlässigen Boden hindurchtreten und auf das verfestigbare Medium zwischen Trägerplatte und Beckenboden treffen. Dieses verfestigt in den Bereichen, in denen es der UV-Strahlung ausgesetzt ist. An Stellen, an denen es aufgrund von Mustern, Bildern oder anderen Formen der Belichtungsanlage keine UV-Strahlung ausgesetzt ist, verfestigt sich das Medium nicht.

Der Abstand der Trägerplatte zur Belichtungsanlage wird nach einer Belichtungszeit erhöht. Hierdurch fließt verfestigbares Medium zwischen Belichtungsanlage und der zuletzt aufgebrachten und verfestigten Schicht nach. Durch die Sequenz aus Belichtung über eine definierte Zeit und anschließendes Verfahren der Trägerplatte, vorzugsweise in vertikaler Richtung weg von der Belichtungsanlage und das Nachfließen des Mediums, wird Schicht um Schicht des verfestigbaren Mediums verfestigt. Durch das Belichten mit UV-Strahlung kommt es hierbei zu einer Polymerisation des belichteten verfestigbaren Mediums. Die Polymerisation ist eine chemische Reaktion, bei der sich Moleküle mit langen Ketten bilden, welche aus mehreren miteinander verbundenen Monomeren und/oder Polymeren bestehen. Die UV-Strahlung fungiert hierbei als Katalysator. So entsteht durch Wiederholung dieser Sequenz eine erhabene Struktur auf der Trägerplatte durch verfestigte Polymere.

Gemäß einer weiteren bevorzugten Ausführungsform besteht die Belichtungsanlage aus mindestens zwei Projektoren, welche ein Bild derart projizieren, dass durch Kantenverschneidung und Stapeln von mehreren Bildern ein zusammenhängendes Bild entsteht. Unter Kantenverschneidung ist hierbei zu verstehen, dass die Außen-/ bzw. Randbereiche mindestens zweier projizierter Bilder gleich sind und somit in einer Überlappung projiziert werden können. Durch diese Überlappung entsteht ein durchgängiges Bild, ohne dass eine Kante zwischen den beiden projizierten Bildern entsteht. Durch diese Überlappung werden die mindestens zwei Bilder in Randbereichen gestapelt.

Auf diese Weise ist es möglich, ein großes zusammenhängendes Bild aus beliebig vielen einzelnen Bildern zusammenzufügen. Dies hat den Vorteil, dass die Auflösung des Bildes so beschaffen ist, dass eine feine Struktur abgebildet werden kann. Bei dem Verwenden nur eines Projektors im Vergleich, wäre die Auflösung und somit auch der Detailgrad, der abgebildet werden kann, schlechter, oder die Größe des zu projizierenden Bildes wäre begrenzt.

Auch der Abstand von Belichtungsanlage zum UV-durchlässigen Boden kann klein gehalten werden. Dies weist Vorteileile in der Gesamtgröße der Anlage auf. Sie kann somit bei verbesserter Auflösung kompakter und platzsparender gestaltet werden.

In einer anderen bevorzugten Ausführungsform weist die Belichtungsanlage mindestens einen Bildschirm auf, welcher UV-Strahlung emittiert. Jegliches andere bildschirmartige und/oder UV-Strahlung aussendendes Gerät kann natürlich auch Verwendung finden.

Bevorzugt emittiert die Belichtungsanlage UV-A-Strahlung in einem Wellenlängenbereich von 300 nm bis 410 nm, bevorzugt 320 nm bis 400 nm, besonders bevorzugt 340 nm bis 380 nm.

In einer bevorzugten Ausführungsform ist die Dicke der Schicht von verfestigtem Medium in einem Bereich von 0,01 mm bis 3 mm, besonders bevorzugt in einem Bereich von 0,02 mm bis 2 mm, besonders bevorzugt in einem Bereich von 0,025 mm bis 1,5 mm. Ist die Schicht zu dick, durchdringt die UV-Strahlung das verfestigbare Medium nur unzureichend, so dass keine genügende Verfestigung eintritt. Bei zu geringem Abstand können Bereiche entstehen, in denen das Medium aufgrund seiner Viskosität nicht nachfließen kann. Somit wäre der Schichtaufbau gestört.

In einer bevorzugten Ausführungsform können die Schichten derartig auf die Trägerplatte aufgebracht werden, dass die erhabene Struktur nicht nur gerade Seiten, sondern auch jegliche andere Art von Form und Kontur, bzw. Relief aufweist. So sind erhabene Strukturen in der Art eines Kegelstumpfes, eines umgedrehten Kegelstumpfes, oder auch jegliche Art von konkaven und konvexen Formen möglich. Eine solche Seitenform ist darstellbar, indem die einzelnen Schichten von verfestigtem Medium mit geringfügig anderen Bildern und Mustern belichtet werden. So kann zur Herstellung eines Kegelstumpfes ein Bereich, der belichtet wird, von Schicht zu Schicht kleiner werden. Auch ist es möglich, einen umgedrehten Kegelstumpf darzustellen, indem der belichtete Bereich mit jeder Schicht, die verfestigt wird, etwas größer wird. Müssen besonders feine Formen der Seiten dargestellt werden, kann die Dicke der Schichten von verfestigbarem Medium entsprechend verringert werden. Je geringer die Schichtdicke, desto feiner kann die Kontur der Seitenfläche dargestellt werden. Mithilfe der unterschiedlichen Seitenformen kann die Stabilität während des Flexo Drucks erhöht werden. Zudem ist es möglich, durch Änderung der Kraft, die die Druckwalze beim Drucken auf die Flexo Druckplatte überträgt, die Druckfläche minimal zu ändern. So kann z.B. bei einer Kegelstupfform durch verstärktes Anpressen an den zu bedruckenden Gegenstand eine leichte Vergrößerung der Druckfläche erfolgen. Auch kann die Seitenform dermaßen gestaltet sein, dass sie bei der Herstellung eine Neigung und/oder Form aufweist, die beim Aufspannen auf die Walze, und das damit verbundene Biegen der erhabenen Struktur, sich eine gewünschte Form ergibt.

In einer anderen bevorzugten Ausführungsform sind flache und auch annähernd runde oder abgerundete Druckoberflächen der erhabenen Struktur darstellbar, diese können sowohl konkav als auch konvex sein. Um eine abgerundete Druckoberfläche zu erlangen, kann es vorteilhaft sein, die Dicke der Schichten von verfestigbarem Medium dünner zu wählen als beim Aufbau von weniger komplex geformten Schichten. Auch hier kann die Druckoberfläche der erhabenen Struktur dermaßen gestaltet sein, dass sie bei der Herstellung eine Form aufweist, die beim Aufspannen auf die Walze, und das damit verbundene Biegen der erhabenen Struktur, eine gewünschte andere Form für den Flexo Druck ergibt. So kann z.B. die erhabene Struktur während der Produktion der Druckplatte eine leicht konkave Wölbung aufweisen, die so beschaffen ist, dass sich durch das Aufspannen auf eine Druckwalze und das damit verbundene Biegen der erhabenen Struktur der Flexo Druckplatte eine exakt gerade Druckoberfläche mit scharfen Kanten ergibt.

In einer weiteren bevorzugten Ausführungsform wird die Oberflächenstruktur der erhabenen Struktur mithilfe der letzten Schicht, oder den letzten Schichten, die aufgebracht wird die gewünschte Oberflächenstruktur aufgebracht. So können z.B. Riefen, Rillen, punktartige Vertiefungen oder Erhöhungen aufgebracht werden. Dies dient zu einer besonders vorteilhaften Farbaufnahme und Abgabe beim Flexo Druck.

Gemäß einer weiteren bevorzugten Ausführungsform kann die Haltevorrichtung die Trägerplatte mit Hilfe einer Verfahreinrichtung in vertikaler und/oder horizontaler Richtung bewegen und in einer definierten Lage halten und/oder die verfestigte erhabene Struktur aus verfestigbarem Medium an der Trägerplatte aus dem Becken verfahren.

Die Trägerplatte kann z.B. für ein besseres Lösen der erhabenen Struktur ausgerichtet werden. In einer vorteilhaften Ausführungsform kann die Haltevorrichtung verwendet werden, um die Trägerplatte exakt zu positionieren. Geringe Abweichungen des Abstandes von Trägerplatte zur Belichtungsanlage sind für eine prozesssichere Herstellung der erhabenen Struktur aus verfestigbarem Medium vorteilhaft. Ungenauigkeiten bei der Einstellung könnten zu Ablösungen der erhabenen Struktur von der Trägerplatte und/oder bei einer Anordnung der Belichtungsanlage unter dem Becken zu Anhaftungen am Beckenboden führen.

Um ein Anhaften des durch die UV-Strahlung verfestigten Mediums an dem UV-Durchlässigen Beckenboden zu verhindern, ist in einer weiteren vorteilhaften Ausführung eine Beschichtung des UV-durchlässigen Beckenbodens möglich. Eine gezielte vertikale und/oder horizontale Relativbewegung von Trägerplatte und UV-durchlässigem Beckenboden ist in einer weiteren bevorzugten Ausführungsform möglich.

In einer weiteren bevorzugten Ausführungsform ist der Abstand von Belichtungsanlage und Becken variabel, indem diese zueinander horizontal und/oder vertikal verschiebbar angeordnet sind. Hierdurch werden Wartungsarbeiten erleichtert.

Da der Aufbau der erhabenen Struktur aus Schichten des zu Beginn flüssigen und verfestigbaren Mediums, welches sich im Becken befindet, erfolgt, sinkt mit jeder Schicht dessen (unverfestigte) Menge im Becken. Das Einstellen des Füllstandes des Beckens mit dem verfestigbaren Medium kann zu Beginn erfolgen. Der Füllstand kann hierbei händisch über ein Befüllen mit dem Medium aus z.B. Kanistern eingestellt werden.

In einer bevorzugten Ausführungsform ist die Trägerplatte opak für UV-Strahlung, so dass nur verfestigbares Medium zwischen Belichtungsanlage und Trägerplatte durch die UV-Strahlung verfestigt wird. Verfestigbares Medium, das sich auf der entgegengesetzten Seite der Belichtungsanlage befindet, wird somit nicht verfestigt.

In einer weiteren bevorzugten Ausführungsform, bevorzugt in der Variante mit Belichtungsanlage unter dem Becken, kann die Trägerplatte auch durchlässig für UV-Strahlung sein. Hierbei umschließt das verfestigbare Medium nicht die Trägerplatte. Füllstand des Beckens und Position der Trägerplatte werden hierbei so gewählt, dass die der Belichtungsanlage entgegengesetzte Seite der Trägerplatte aus dem verfestigbaren Medium herausragt. Hierfür kann nach jeder, oder auch nach mehreren Belichtungen mit der Belichtungsanlage der Füllstand des Beckens mit verfestigbarem Medium angepasst werden.

In einer weiteren bevorzugten Ausführungsform ist die Dicke der Trägerplatte dermaßen dimensioniert, dass keine Anpassung des Füllstands des verfestigbaren Mediums während der gesamten Herstellung der erhabenen Struktur der Flexo Druckplatte erfolgen muss, da die der Belichtungsanlage entgegengesetzte Seite der Trägerplatte aus dem verfestigbaren Medium herausragt. In einer bevorzugten Ausführungsform weist das Becken mindestens einen Zulauf und auch mindestens einen Ablauf für das verfestigbare Medium auf. Über den Zulauf kann das verfestigbare Medium in das Becken eingefüllt und über den Ablauf aus dem Becken abgelassen werden. Hierdurch ist es möglich, dass auch noch während eines Herstellungsprozesses das Medium nachgefüllt werden kann. Dies lässt eine sehr genaue Steuerung der Mengen zu, so dass die Herstellung ressourcen- und kostenschonend erfolgen kann. Auch das Einregeln einer konstanten Füllmenge, oder das bewusste Absenken oder Erhöhen der Füllmenge ist hierdurch möglich. Zu Reinigungszwecken kann das verfestigbare Medium zudem über mindestens einen Abfluss des Beckens entleert werden. Da das verfestigbare Medium lichtempfindlich ist, kann es auch nach Beendigung einer Produktion über den Abfluss in entsprechende UV- und Lichtundurchlässige Behältnisse abgefüllt werden. Alternativ kann das überschüssige verfestigbare Medium auch von der Trägerplatte mit der erhabenen Struktur und/oder aus dem Becken abgesaugt werden.

In einer weiteren bevorzugten Ausführung erfolgt die Ansteuerung der Belichtungsanlage mittels RIP (Raster Image Prozessor). Hierbei werden Daten, die zum Erstellen einer Grafik verwendet werden, in binärem Code übermittelt.

Die Erfindung betrifft außerdem ein Verfahren zur Herstellung von Flexo Druckformen nach Anspruch 6, bei dem eine Trägerplatte an einer Haltevorrichtung in ein mit einem verfestigbaren Medium befüllbares Becken eingetaucht und zumindest partiell in frei wählbaren Bereichen mittels einer Belichtungsanlage mit UV-Licht bestrahl wird. Das Verfahren umfasst mehrere aufeinanderfolgende Schritte :
a Eintauchen der Trägerplatte an der Haltevorrichtung in das Becken mit verfestigbarem Medium;
b Einstellen der Dicke einer Schicht (4) des verfestigbaren Mediums zwischen Trägerplatte und Belichtungsanlage durch eine Relativbewegung von Trägerplatte und Becken;
c Belichten von frei wählbaren Bereichen des verfestigbaren Mediums der Schicht zwischen Trägerplatte und Belichtungsanlage zur Verfestigung des verfestigbaren Mediums mittels UV-Licht der Belichtungsanlage;
d Wiederholung der Schritte b und c zur Herstellung von Schichten aus verfestigtem Medium zu einer verfestigten und erhabenen Struktur aus dem verfestigbaren Medium auf der Trägerplatte.
e Herausfahren der Trägerplatte mit der hergestellten erhabenen Struktur aus Schichten von verfestigtem Medium durch eine Relativbewegung von Becken und Trägerplatte.

Prinzipiell wird in diesen Schritten auf eine Trägerplatte ein verfestigbares Medium aufgetragen. Dieser Auftrag kann punktuell oder in Bereichen erfolgen. So können alle Arten von Formen und Mustern dargestellt werden. Die genannten Schritte bauen logisch aufeinander auf und sind eine bevorzugte Ausführungsform der Erfindung. Jedoch ist auch eine andere Reihung dieser Schritte möglich, ohne den generellen Gedanken dieser Erfindung zu verlassen.

In einem ersten Arbeitsschritt wird die Trägerplatte in das Becken mit einem verfestigbaren Medium getaucht.

In einem zweiten Schritt wird die Dicke einer Schicht des zu verfestigenden Mediums zwischen Trägerplatte und Belichtungsanlage durch eine Relativbewegung von Trägerplatte und Becken eingestellt. Eine definierte Dicke der Schicht ist notwendig, um die gewünschte Verfestigung des Mediums zu erhalten. Bei einer zu großen Schichtdicke ist zu viel Medium vorhanden, welches nicht genügend von der UV-Strahlung verfestigt werden kann. Ist die Dicke zu gering, kann es zu Fehlstellen kommen, da aufgrund der Viskosität des verfestigbaren Mediums nicht genügend oder gar kein Medium nachfließen kann. Auch eine Beschädigung von Trägerplatte und/oder Becken könnte je nach Ausführungsform der Anlage durch eine ungenaue Einstellung und einer dadurch möglichen Berührung der beiden zustande kommen.

Ist die gewünschte Schichtdicke des verfestigbaren Mediums eingestellt, folgt als nächster Schritt die Belichtung mit UV-Strahlung. Die Belichtungszeit ist definiert, um eine genügende Verfestigung des Mediums zu gewährleisten. Eine zu lange Belichtungszeit des Mediums muss hingegen auch vermieden werden, damit die Schichten nicht zu weit aushärten, da sie ansonsten nicht mehr die für Flexo Druck benötigte Flexibilität der Druckform zum Aufspannen auf einer Walze aufweisen.

Nach der Belichtungszeit hat sich eine erhabene Schicht auf der Trägerplatte, bzw. in Wiederholungen eine weitere Schicht auf der vorangegangenen Schicht, gebildet. Somit ist bis zum Erreichen der gewünschten erhabenen Struktur das Einstellen der gewünschten Schichtdicke zu wiederholen. Hierbei muss der Abstand der Trägerplatte relativ zur Belichtungsanlage um die Höhe einer Schichtdicke vergrößert werden, so dass das verfestigbare Medium nachfließen und eine neue zu verfestigende Schicht bilden kann, bevor eine neue Belichtung erfolgen kann.

Ist die gewünschte Dicke der erhabenen Struktur durch Wiederholen der genannten Schritte erreicht, wird die Trägerplatte mit der anhaftenden verfestigten erhabenen Struktur, bestehend aus mindestens einer Schicht, bevorzugt mehreren Schichten an verfestigtem Medium, aus dem Becken gehoben, bzw. herausgefahren. Hierbei ist es nicht nur denkbar, dass die Trägerplatte aus dem Becken fährt, ein Verfahren des Beckens ist ebenso möglich. Auch die Kombination aus Verfahren des Beckens und Verfahren der Trägerplatte relativ zueinander ist denkbar.

Weiterführende Schritte des Verfahrens sind
f Bestrahlung der hergestellten erhabenen Struktur mit UV-A und/oder UV-C Strahlung;
g Trennen der hergestellten erhabenen und schichtweise verfestigten Struktur von der Trägerplatte, wobei der Schritt f auch nach dem Schritt g erfolgen kann.

Die erhabene Struktur des verfestigbaren Mediums ist nach der Produktion zwar verfestigt, weist aber eine klebrige Oberfläche auf. Mithilfe einer weiteren Bestrahlung zum Verfestigen mit UV-A und/oder zum Entkleben der Oberfläche mit UV-C ist es möglich, eine gezielte weitere Verfestigung der Druckform, bis hin zu der gewünschten Flexibilität zu erlangen.

In einer bevorzugten Ausführungsform erfolgt hierbei zuerst eine Behandlung mit UV-A Strahlung zum Verfestigen. Im Anschluss folgt zum Entkleben der Oberfläche der Druckform eine weitere Aushärtung mit UV-C Strahlung. Nach diesem Arbeitsschritt kann die produzierte Druckform, bestehend aus der erhabenen Struktur, von der Trägerplatte abgelöst werden.

In einer weiteren bevorzugten Ausführungsform erfolgt zuerst die Bestrahlung mit UV-A Strahlung zur Verfestigung; danach wird die Druckform von der Trägerplatte abgelöst und dann einer UV-C Strahlung zum Entkleben ausgesetzt. Prinzipiell kann die Reihenfolge der Schritte Bestrahlung mit UV-A Strahlung und UV-C Strahlung und das Ablösen in verschiedenen Reihenfolgen erfolgen. Denkbar ist auch eine mehrmalige Bestrahlung mit UV-A und UV-C Strahlung vor und/oder nach dem Ablösen der Druckform von der Trägerplatte.

Die UV-Strahlung zum Verfestigen der erhabenen Struktur liegt im gleichen Bereich, wie die UV-Strahlung zum Verfestigen der einzelnen Schichten des verfestigbaren Mediums zum Aufbau der erhabenen Struktur. Somit liegt sie in dem Wellenlängenbereich einer UV-A Strahlung. Der Wellenlängenbereich ist von 300 nm bis 410 nm, bevorzugt 320 nm bis 400, besonders bevorzugt 340 bis 380 nm.

Zum Entkleben der erhabenen Struktur wird bevorzugt UV-C Strahlung in einem Wellenlängenbereich von 90 nm bis 300 nm, bevorzugt 100 nm bis 280 nm, besonders bevorzugt 150 nm bis 240 nm, verwendet. Hierdurch wird eine verfestigte, nicht klebende Oberflächenstruktur erreicht, die für das spätere Verwenden der erhabenen Struktur als Druckform dienlich ist.

Bevorzugt ist die erhabene Struktur auch nach den vorangegangenen Arbeitsgängen, in denen UV-Strahlung unterschiedlicher Wellenlänge eingesetzt wird, noch flexibel. Die Flexibilität der Flexo Druckplatte und die Oberflächengüte ist vielmehr durch die UV-Strahlung so beeinflusst, dass sie sich positiv auf den Verschleiß und die Druckqualität beim Drucken auswirkt. Die Druckplatte ist also so verfestigt, dass sie robust gegen verschließ beim Drucken ist. Sie ist allerdings auch so flexibel, dass sie auf eine Druckwalze aufgespannt werden kann.

Die Behandlung der Druckplatte mit UV-A Strahlung zum Verfestigen und/ oder UV-C Strahlung zum Entkleben wird bevorzugt mit einer homogenen Belichtung durchgeführt.

Gemäß einer weiteren bevorzugten Ausführungsform des Verfahrens erfolgt der Aufbau von Schichten auf einem flexiblen Grundmaterial, welches an der Trägerplatte angeordnet ist und/oder das Grundmaterial weist eine flexible Stützstruktur auf, auf der die Schichten von verfestigbarem Medium aufgebracht werden. Das Grundmaterial kann durch mehrere Lagen des belichteten verfestigbaren Mediums hergestellt werden.

In einer anderen bevorzugten Fertigung wird schon vor dem Prozess des Belichtens ein Grundmaterial an der Trägerplatte befestigt, um dieses dann ins Becken mit verfestigbaren Medium einzutauchen, so dass direkt mit dem Aufbau der erhabenen Struktur, bzw. von Mustern, begonnen werden kann. Dieses Grundmaterial ist somit nach der Fertigung mit der aufgebauten erhabenen Struktur verbunden und somit Teil der Druckform.

In einer bevorzugten Ausführungsform wird ein Grundmaterial aufgebracht, in dem eine flexible Stützstruktur eingearbeitet ist. Diese Stützstruktur verhindert eine Längung der späteren Druckform und verhindert, bzw. schränkt einen Verzug dieser ein. Bevorzugt wird diese Struktur auch eingesetzt, um ein Lösen der erhabenen Struktur von der Trägerplatte zu verhindern.

In einer bevorzugten Ausführungsform kann das Grundmaterial und/oder die Stützstruktur eine andere Festigkeit als die aufgebrachte erhabene Struktur aufweisen. Somit kann eine harte und damit verschleißarme Druckoberfläche mit einem weichen und gut an einer Flexo Druckwalze befestigbaren Grundmaterial und/oder Stützstruktur kombiniert werden. Zudem kann hierdurch die Flexo Druckplatte, im Vergleich zu einer Flexo Druckplatte aus nur einem einzigen Material mit durchgängig gleicher Festigkeit, auch mit einem geringeren Materialeinsatz gefertigt werden.

In einer weiteren vorteilhaften Ausführungsform wird nur die Stützstruktur auf die Trägerplatte aufgebracht und dann mit dem Aufbau der ersten Schichten begonnen. Für eine bessere Integration der Stützstruktur kann in einer weiteren vorteilhaften Ausführungsform zuerst mindestens eine Schicht des verfestigbaren Mediums auf die Trägerplatte aufgebaut werden, dann die Stützstruktur eingebracht und dann mit dem Verfestigen weiterer Schichten fortgefahren werden. Die flexible Stützstruktur kann in einer weiteren bevorzugten Ausführungsform aus einer Folie oder einem Netz bestehen. Die Stützstruktur besteht vorteilhaft aus Polyester, Polyacryl oder auch aus Naturfasern.

In einer bevorzugten Ausführungsform können die Formate der Druckform bis hin zu der Größe der Trägerplatte in Länge und Breite frei gewählt werden. Die Druckplatten weisen zudem durch die additive Fertigung eine geringe Höhe, bzw. Plattenstärke auf. Die Höhe der Druckplatte kann in einem Beriech von 0,4 mm bis 10 mm liegen, bevorzugt 0,5 mm bis 7 mm und besonders bevorzugt von 0,76 mm bis 6,35 mm.
Figur 1: Schematischer Aufbau einer Anlage zur Herstellung von Flexo Druckformen in zweidimensionaler Ansicht.
Figur 2: Schematischer Aufbau einer Anlage zur Herstellung von Flexo Druckformen in dreidimensionaler Ansicht.
Figur 3: Schematischer Aufbau einer Anlage zur Herstellung von Flexo Druckformen in zweidimensionaler Ansicht
Figur 4: Schematische Darstellung eines Bildes mit Kantenverschneidung und Stapeln.
Figur 5: Schematische Darstellung einer Flexo Druckplatte.
Figur 6: Schematische Darstellung einer Flexo Druckplatte
Figur 7: Schematische Darstellung einer Flexo Druckplatte mit unterschiedlichen Oberflächenstrukturen
Figur 8a: Schematische Darstellung einer Flexo Druckplatte in flacher Lage
Figur 8b: Schematische Darstellung einer Flexo Druckplatte aufgespannt auf einer Walze
Figur 9: Ablaufplan eines Druckverfahrens.

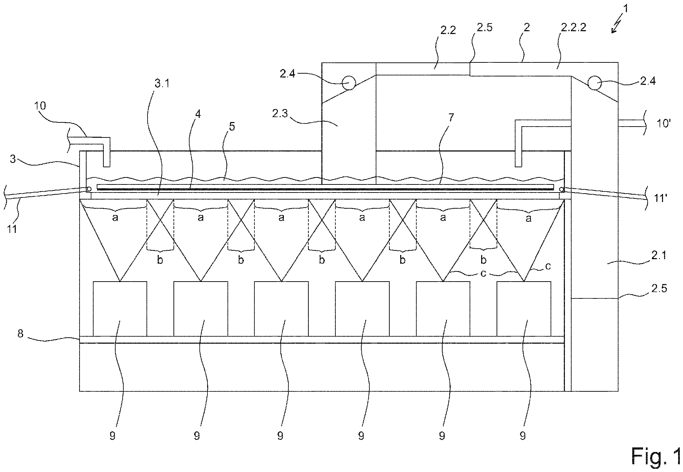

Figur 1 zeigt beispielhaft den schematischen Aufbau einer Anlage 1 zur Herstellung von Flexo Druckformen. Die Hauptbestandteile der Anlage sind das Becken 3, die Belichtungsanlage 8 und eine Haltevorrichtung 2, an der eine Trägerplatte 7 angebracht ist. Das Becken 3 besitzt einen Boden 3.1, der für UV-Strahlung durchlässig ist. Somit kann über die Belichtungsanlage 8 das Becken 3 von unten belichtet werden und das hierin befindliche verfestigbare Medium 5 bestrahlt werden, so dass eine Schicht von verfestigtem Medium 4 zwischen Beckenboden 3.1 und Trägerplatte 7 durch Belichtung mit der Belichtungsanlage 8 entsteht. Die Belichtungsanlage 8 besteht aus mehreren Projektoren 9, die so angeordnet sind, dass sie den UV-durchlässigen Beckenboden 3.1 anstrahlen. Die Anzahl von sechs Projektoren 9 ist exemplarisch gewählt, jede andere Anzahl ist auch möglich. Hierbei sind die Projektoren 9 mit ihrem Strahlkegel c dermaßen angeordnet, dass ein Projektor 9 jeweils einen Bereich a einzeln belichtet und ein Bereich b überlappend mit einem weiteren, benachbarten Projektor 9 belichtet. Somit findet in dem überlappenden Bereich b eine Kantenverschneidung durch Stapeln von einzelnen Bildern statt. Hierdurch ist es möglich, in einer feinen Auflösung mit hohem Detaillierungsgrad große Bereiche mit UV-Strahlung zu belichten. Es entstehen hierbei keine Kanten zwischen den einzelnen Bildern, die Einfluss auf die Qualität nehmen könnten. Es besteht somit kein Abwägen zwischen Größe der zu bestrahlenden Fläche und Genauigkeit, bzw. Auflösung. Die Auflösung liegt in einem Bereich von 2000 dpi bis 10100 dpi, bevorzugt in einem Bereich von 2400 dpi bis 10000 dpi und besonders bevorzugt in einem Bereich von 3000 dpi bis 9500 dpi.

Das Becken 3 besitzt einen UV-durchlässigen Boden 3.1 und ist zum Befüllen mit einem verfestigbaren Medium 5 bestimmt. Über mindestens einen Zulauf 10, in diesem Beispiel zwei Zuläufe 10, 10', wird das Becken 3 mit dem verfestigbaren Medium 5 befüllt. Zu Reinigungszwecken oder, da das Medium 5 lichtempfindlich ist, kann es nach der Produktion einer Druckform, also einer erhabenen Struktur 6, durch einen Ablauf 11, bzw. Abläufe 11 und 11' wieder abgelassen werden. Hierdurch wird ein ressourcenschonender Umgang mit dem Medium 5 erreicht. Zudem sind ein gezieltes Befüllen und Entleeren des Beckens 3 auch während der Produktion möglich. Der Füllstand kann mit dieser Vorrichtung aus Zu- und Ablauf 10, 11 gesteuert oder geregelt werden.

Die Trägerplatte 7 ist an einer Haltevorrichtung 2 befestigt. Hierdurch ist es möglich, den Abstand von Trägerplatte 7 zum UV-durchlässigen Beckenboden 3.1 exakt einzustellen. Hierüber wird bestimmt, wie dick die Schicht des verfestigbaren Mediums 4 ist, die bei einer Belichtung aufgebaut wird. Die Trägerplatte 7 ist vorteilhaft so angebracht, dass sie nicht nur präzise positioniert werden kann, sondern auch für Wartungs- und Wechselarbeiten leicht zugänglich ist. In diesem Ausführungsbeispiel ist sie daher an einer Haltevorrichtung 2 angebracht, die aus einem Ständer 2.1 und einem horizontalen Arm 2.2 besteht. Um die Trägerplatte 7 verfahren zu können, befinden sich im Ständer 2.1 und/oder im horizontalen Arm 2.2 je eine Verfahreinrichtung 2.5, welche ein Verschieben der Trägerplatte 7 in horizontaler und/oder in vertikaler Richtung ermöglichen. Zudem sind Drehgelenke 2.4 zwischen Ständer 2.1 und horizontalem Arm 2.2, sowie zwischen horizontalem Arm 2.2 und vertikalem Arm 2.3vorgesehen, die vorzugsweise in alle Raumrichtungen drehbar gelagert sind, um ein genaues Ausrichten der Trägerplatte 7 zum Beckenboden 3.1 zu ermöglichen. Des Weiteren können diese Vorrichtungen dazu verwendet werden, die Trägerplatte 7 so zu heben und zu drehen, dass ein Arbeiten an dieser möglichst bedienerfreundlich ist. So kann zum Entnehmen einer produzierten Druckform die Trägerplatte 7 angehoben und seitlich verfahren und/oder geneigt werden, so dass sie für den Arbeiter leicht zu entnehmen ist.

Durch das Belichten mit UV-Strahlung von der Belichtungsanlage 8 verfestigen die belichteten Bereiche 12 des verfestigbaren Mediums 5. Die belichteten Bereiche 12 können hierbei Muster, Bilder und Formen aller Art aufweisen, so dass Schichten von verfestigtem Medium 4 entstehen.

Bevorzugt ist der Aufbau der Anlage 1 in einer für UV-Strahlung und Licht undurchlässigen, abgeschlossenen Kammer untergebracht, da das verfestigbare Medium 5 lichtempfindlich ist und die UV-Strahlung für den Anwender gesundheitsschädlich sein kann.

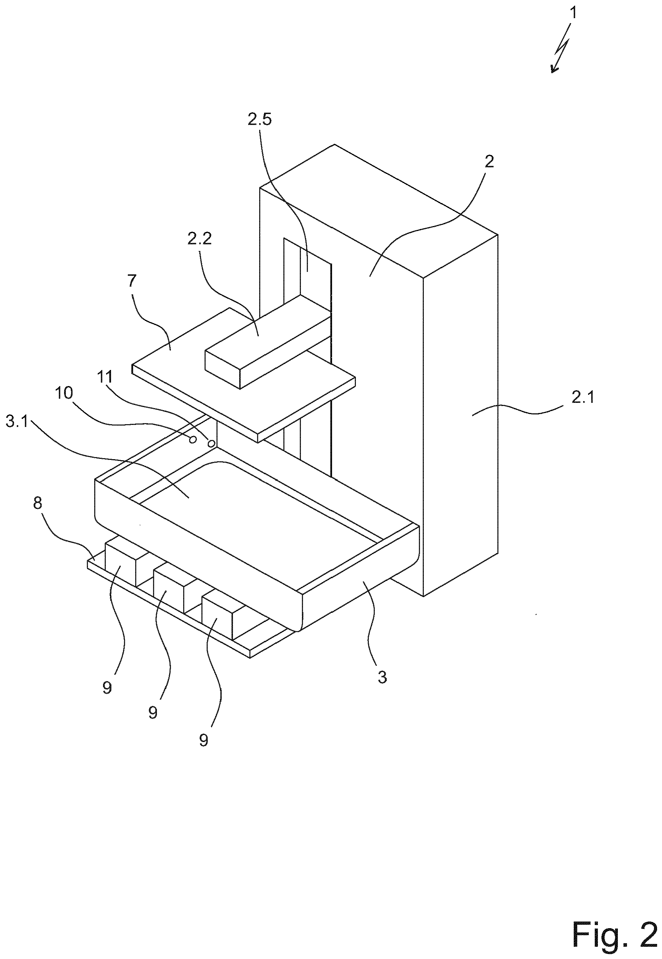

Figur 2 zeigt beispielhaft den schematischen Aufbau einer Anlage 1 zur Herstellung von Flexo Druckformen in einer dreidimensionalen Ansicht. An einer Haltevorrichtung 2, die aus einem Ständer 2.1 und einem horizontalen Arm 2.2 besteht, ist eine Trägerplatte 7 angebracht. Mit Hilfe der Haltevorrichtung 2 kann diese in das Becken 3 abgesenkt werden und eine exakte Positionierung in Bezug auf den UV-durchlässigen Beckenboden 3.1 erzielt werden.

In dieser Ausführung der Anlage 1 besteht die Belichtungsanlage 8 aus Projektoren 9, die so angeordnet sind, dass sie durch Kantenüberschneidung und Stapelung ein durchgängiges Bild auf den UV-durchlässigen Beckenboden 3.1 projizieren können. Mit einer solchen Anordnung ist die Projektion eines detailreichen Musters, bzw. Bildes in hoher Auflösung möglich, selbst punktförmige, fein aufgelöste Muster und Formen sind fertigbar.

Mit der Anlage 1 dieser Funktionsweise kann die Größe der zu fertigenden Druckplatten bis zu der maximalen Größe der Trägerplatte 7 frei gewählt werden. Kleinere Formate können erzeugt werden, indem die äußeren Bereiche der Trägerplatte 7 nicht mit UV-Licht bestrahlt werden. Die Druckplatten können zudem durch die additive Fertigung mit einer recht geringen Höhe ausgeführt werden.

Zulauf 10 und Ablauf 11 des verfestigbaren Mediums 5 sind bevorzugt in einer Ecke des Beckens 3 angebracht. Hierdurch kann die Füllmenge des verfestigbaren Mediums 5 angepasst werden. Die Anlage kann, um sie von einem äußeren Lichteinfall zu schützen, in einem für UV-Strahlung und Licht undurchlässigen Gehäuse untergebracht sein.

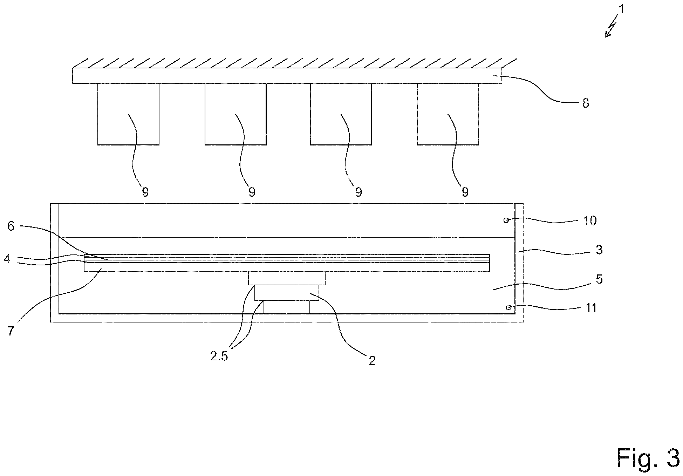

Figur 3 zeigt den schematischen Aufbau einer Anlage 1 zur Herstellung von Flexo Druckformen, bei der die Belichtungsanlage 8 oberhalb des Beckens 3 angeordnet ist. Die Belichtungsanlage 8 mit den Projektoren 9 strahlt in dieser Anordnung auf das Becken 3 mit der Trägerplatte 7 herab. In dem Becken 3 ist die Trägerplatte 7 an einer Haltevorrichtung 2 angebracht. In der Haltevorrichtung 2 sind Verfahreinrichtungen 2.5 integriert, die eine vertikale Verschiebung der Trägerplatte 7 ermöglichen. Auf der Trägerplatte 7 werden Schichten von verfestigtem Medium 4 durch die Belichtung mit der Belichtungsanlage 8 verfestigt. Durch Anschließendes Verfahren der Trägerplatte 7 vertikaler in Richtung des Beckenbodens und Nachfließen des verfestigbaren Mediums 4 und anschließend einem erneuten Belichten wird Schicht 4 um Schicht 4 eine erhabene Struktur 6 aufgebaut. Sämtliche Merkmale, die in Zusammenhang mit der Ausführungsform offenbart sind, bei welcher die Belichtungsanlage 8 unterhalb des Beckens 3 angeordnet ist, sind auch mit der Anordnung der Belichtungsanlage 8 oberhalb des Beckens 3 kombinierbar, insbesondere Drehgelenke 2.4, Becken 3, Trägerplatte 7, Belichtungsanlage 8 mit Projektoren 9, Zulauf 10 und Ablauf 11 des monomeren Mediums.

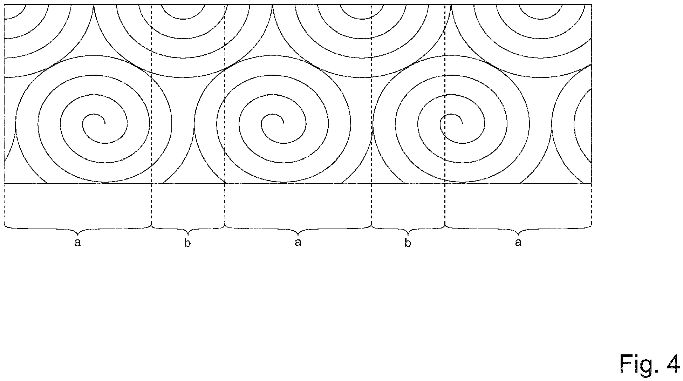

Figur 4 zeigt beispielhaft die schematische Darstellung eines Bildes mit Kantenverschneidung und Stapeln. In dieser beispielhaften Darstellung wird durch Kantenverschneidung und Stapel von drei Bildern ein großes zusammenhängendes Bild erzeugt, ohne dass Kanten zwischen den einzelnen Bildern entstehen. Somit werden die Bereiche a nur von jeweils einem Projektor 9 belichtet, während die Bereiche b jeweils eine Überlappung von 2 Bildern zweier Projektoren 9 aufweist. Um dies zu erreichen, müssen z.B. der rechte Bildrand des linken Bildes und der linke Bildrand des rechts darauffolgenden Bildes gleich sein. Ansonsten käme es zu einer falschen Wiedergabe des Gesamtbildes. Mit Hilfe dieser Technik ist es möglich, eine große Fläche mit hoher Auflösung zu belichten.

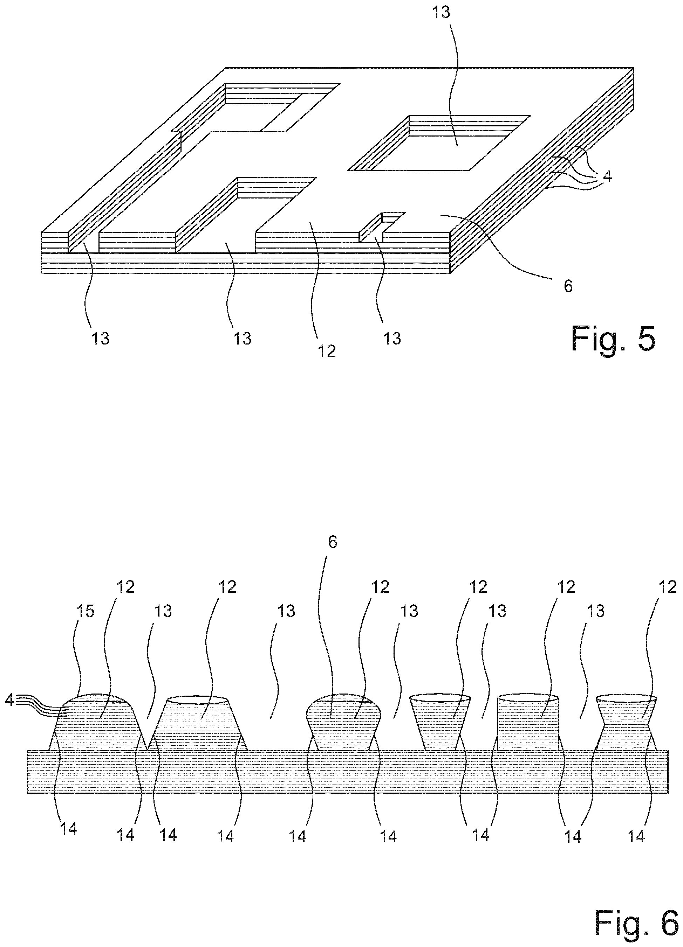

Figur 5 zeigt beispielhaft die schematische Darstellung einer Flexo Druckplatte. Die Druckplatte ist die erhabene Struktur 6, die aus mindestens einer Schicht 4, in der Regel mehreren, von verfestigtem Medium 4 besteht. Wie bereits beschrieben, entstehen diese einzelnen Schichten 4 durch Belichten von verfestigbaren Medium 5 mit UV-Strahlung. Nur in den belichteten Bereichen 12verfestigt sich das verfestigbare Medium 5. So kann durch unbelichtete Bereichen 13 jegliche Art an Mustern, Bildern oder Formen projiziert werden. Das Bild und damit auch die unbelichteten Bereiche 13 können von Schicht 4 zu Schicht 4 variiert werden. So ist es möglich, tiefere und auch flachere Muster herzustellen.

Figur 6 zeigt beispielhaft die schematische Darstellung einer Flexo Druckplatte. Die Flexo Druckplatte besteht aus mehreren Schichten 4 aus verfestigbarem Medium. Die erhabene Struktur 6 kann hierbei je nach Anforderung gestaltet werden. So sind zum Beispiel Seiten 14 der erhabenen Struktur in unterschiedlichen Ausführungsformen möglich. Diese können gerade oder schräg verlaufen oder auch konkave oder konvexe Konturen aufweisen. Auch die Form eines Kegelstumpfes oder eines umgedrehten Kegelstumpfes ist möglich; die Kombination aus Kegelstumpf und umgedrehten Kegelstumpf ist ebenfalls möglich. Auch die Druckfläche 15 kann flach, abgerundet und/oder konkav oder konvex ausgeführt werden. Je dünner die Schichtdicke 4 in diesen Bereichen gewählt ist, desto genauer kann die Rundung und/oder ein Radius dargestellt werden. Möglich wird diese Formung der Seiten 14 und Druckflächen 15 durch minimal unterschiedliche Bilder/Formen bei der Belichtung der belichteten Bereiche 12 von Schicht 4 zu Schicht 4 während der Herstellung der erhabenen Struktur 6.

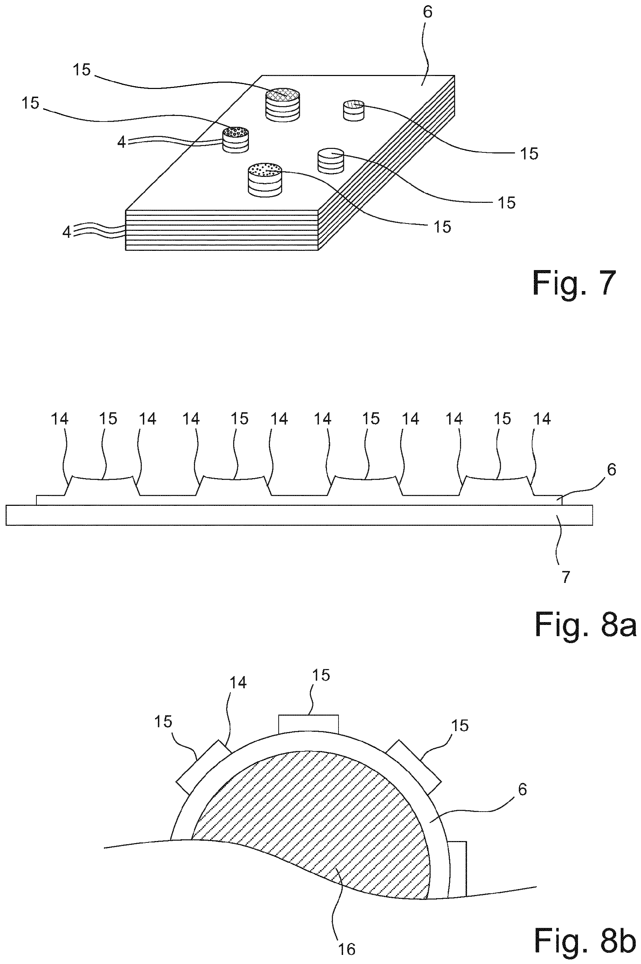

Figur 7 zeigt die schematische Darstellung einer Flexo Druckplatte mit unterschiedlichen Oberflächenstrukturen. Durch die letzte oder die letzten Schichten 4 des verfestigten Mediums kann eine gewünschte Oberflächenstruktur der Druckoberfläche 15 hergestellt werden. So können nicht nur glatte Oberflächen dargestellt werden, sondern auch punktförmige Vertiefungen oder Erhebungen. Auch eine feine Rillenstruktur ist eine mögliche Ausführungsform, ebenso wie eine gekreuzte Rillenstruktur. Diese optimierten Oberflächenstrukturen dienen dazu, die Druckfarbe bestmöglich aufzunehmen und wieder abzugeben und/oder eine gewisse Menge an Druckfarbe zu speichern, um einen homogenen Druck zu erhalten.

Figur 8a zeigt die schematische Darstellung einer Flexo Druckplatte in flacher Lage und Figur 8b die Flexo Druckplatte aufgespannt auf einer Walze 16. Bei der Produktion der Flexo Druckplatte, bzw. der erhabenen Struktur 6 befindet sich diese an der Trägerplatte 7. Diese ist flach, bzw. ohne Krümmung ausgeführt. Für das Flexo Druckverfahren wird die Druckplatte auf eine Flexo Druckwalze 16 aufgespannt. Durch die Walzenform wird die erhabenen Struktur 6 gebogen. Hierdurch wird die erhabene Struktur 6 leicht verformt, bzw. gebogen.

Dies kann während der Herstellung der erhabenen Struktur 6 berücksichtig werden. Die Druckoberfläche 15 und die Seiten 14 sind derart gestaltet, dass sie in flacher Lage eine schräge Seite 14 und eine konkave Druckfläche 15 aufweisen. Dies korrigiert die Verformung der Oberfläche der erhabenen Struktur 6, die durch das Aufspannen auf eine Flexo Druckwalze 16 erfolgt. Im aufgespannten Zustand ist hierdurch eine exakt flache Druckoberfläche 15 der erhabenen Struktur 6 und eine saubere Kante mit keiner oder einer nur sehr geringer Verrundung zur Seitenfläche 14 möglich. Auch die Seitenfläche 14 ist im aufgespannten Zustand senkrecht, bzw. in der bevorzugten Form. Unabhängig von der gewünschten Form von Seite 14 und Druckoberfläche 15 ist die Berücksichtigung der Änderung der erhabenen Struktur 6 durch das Aufspannen auf eine Flexo Druckwalze 16 möglich und so gestaltbar, dass sie im aufgespannten Zustand der Sollform entspricht.

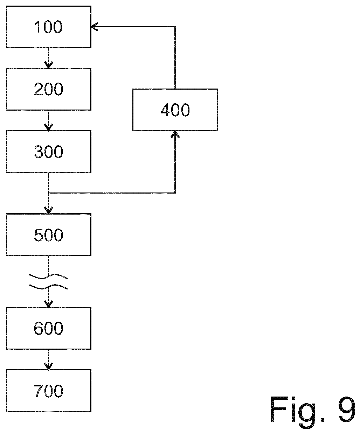

Figur 9 beschreibt beispielhaft den Ablaufplan eines Flexo Druckverfahrens. Hierbei wird in einem ersten Schritt 100 die Trägerplatte 7 an in das Becken 3 mit verfestigbarem Medium 5 eingetaucht. Im nächsten Schritt 200 wird die Dicke einer Schicht 4 des verfestigbaren Mediums 5 zwischen Trägerplatte 7 und Belichtungsanlage 8 durch eine Relativbewegung von Trägerplatte 7 und Becken 3 eingestellt. Im Anschluss hieran folgt der Schritt 300, das Belichten von frei wählbaren Bereichen des verfestigbaren Mediums 5 zwischen Trägerplatte 7 und Belichtungsanlage 8 zum Verfestigen dieses verfestigbaren Mediums 5 mittels UV-Strahlung der Belichtungsanlage 8 in den belichteten Bereichen 12. Hierauf folgt im Schritt 400 die Wiederholung der Schritte 200 und 300 zur Herstellung von Schichten von verfestigtem Medium 4 zu einer verfestigten und erhabenen Struktur 6 aus dem verfestigbaren Medium 5 auf der Trägerplatte 7. Dieser Schritt 400 wird so oft wiederholt, bis die gewünschte Dicke, Form und Struktur der erhabenen Struktur 6 erreicht ist.

Im Anschluss, wenn die gewünschte Dicke der erhabenen Struktur 6 erreicht ist, erfolgt der Schritt 500, das Herausfahren der Trägerplatte 7 mit der hergestellten erhabenen Struktur 6 aus Schichten von verfestigtem Medium 4 durch eine Relativbewegung von Becken 3 und Trägerplatte 7.

Im Anschluss an diese Fertigung der erhabenen Struktur 6, also der Druckplatte, kann zur weiteren Verbesserung der Platteneigenschaften noch weiterführend ein Schritt 600 erfolgen, um die Oberfläche mittels UV-C Strahlung zu entkleben und/oder die Flexo Druckplatte mittels UV-A Strahlung zu verfestigen.

Im letzten Schritt 700 wird die hergestellte verfestigte und erhabene Struktur 6 von der Trägerplatte 7 gelöst. Je nach Ausführungsform der Anlage 1 kann auch zuerst der Schritt 700 erfolgen, und der Schritt 600 dann auf einer anderen Maschine ausgeführt werden. Denkbar ist es auch, dass die erhabene Struktur 6 samt Trägerplatte 7 aus der Anlage 1 entfernt wird und dann der Schritt 600 auf einer anderen Anlage erfolgt, wobei die Trägerplatte 7 hierbei in die andere Anlage umgespannt wird. Somit dient die Trägerplatte 7 nicht nur zum Aufbau der Schichten 4, sondern auch als schützende Lage, solange die verfestigte Struktur 5 noch nicht ihren gewünschten Endzustand bezüglich Verfestigung und Oberflächenbeschaffenheit / Entkleben der Oberfläche erlangt hat.

### Bezugszeichenliste

- 1: Anlage
- 2: Haltevorrichtung
- 2.1: Ständer
- 2.2: Horizontaler Arm
- 2.3: vertikaler Arm
- 2.4: Drehgelenk horizontal und/oder vertikal
- 2.5: Verfahreinrichtung
- 3: Becken
- 3.1: UV-durchlässiger Beckenboden
- 4: Schicht von verfestigtem Medium
- 5: Verfestigbares Medium
- 6: Erhabene Struktur
- 7: Trägerplatte
- 8: Belichtungsanlage
- 9: Projektor
- 10: Zulauf des monomeren oder polymeren Mediums
- 10': Zulauf des monomeren oder polymeren Mediums
- 11: Ablauf des monomeren oder polymeren Mediums
- 11`: Ablauf des monomeren oder polymeren Mediums
- 12: Belichtete Bereiche
- 13: Unbelichtete Bereiche
- 14: Seite der erhabenen Struktur
- 15: Druckoberfläche der erhabenen Struktur
- 16: Flexo Druckwalze
- a: einzelner Bereich
- b: überlappender Bereich
- c: Strahlkegel
- 100: Eintauchen
- 200: Einstellen Schichtdicke
- 300: Belichten
- 400: Wiederholen
- 500: Herausfahren
- 600: Bestrahlung
- 700: Trennen

## Patentansprüche

1. Anlage (1) zur Herstellung von Druckformen für Flexo Druck, umfassend eine Trägerplatte (7) und eine Haltevorrichtung (2), an welcher die Trägerplatte (7) angeordnet ist, ein Becken (3) und eine Belichtungsanlage (8),
wobei das Becken (3) mit einem verfestigbaren Medium (5) befüllbar ist und die Trägerplatte (7) in das verfestigbare Medium (5) eintauchbar ist und die Belichtungsanlage (8) UV-Strahlung in Mustern, Bilder oder anderen Formen auf das verfestigbare Medium (5) abstrahlen kann,
**dadurch gekennzeichnet, dass**
die Trägerplatte (7) und die Belichtungsanlage (8) so angeordnet sind, dass zumindest eine Schicht verfestigbaren Mediums (5) zwischen einer Hauptseite der Trägerplatte (7) und der Belichtungsanlage (8) mit UV-Strahlung belichtbar und an der Trägerplatte (7) verfestigbar ist,
wobei die Trägerplatte (7) im Becken (3) justierbar ist und eine Schichtdicke der Schicht (4) des verfestigbaren Mediums (5) zwischen Trägerplatte und Belichtungsanlage (8) durch eine Relativbewegung von Trägerplatte (7) und Becken (3) einstellbar ist.

2. Anlage (1) nach Anspruch 1,
**dadurch gekennzeichnet, dass**
die Belichtungsanlage (8) über oder unter dem Becken (3) angeordnet ist, wobei das Becken (3) einen UV-durchlässigen Beckenboden (3.1) aufweist, wenn die Belichtungsanlage (8) unter dem Becken angeordnet ist.

3. Anlage (1) nach Anspruch 1 oder 2,
**dadurch gekennzeichnet, dass**
die Belichtungsanlage (8) aus mindestens zwei Projektoren (9) besteht, welche ein Bild derart projizieren, dass durch Kantenverschneidung und Stapeln von mehreren Bildern ein zusammenhängendes Bild entsteht.

4. Anlage (1) nach einem der vorangegangenen Ansprüche,
**dadurch gekennzeichnet, dass**
die Dicke einer Schicht von verfestigtem Medium (4) eingestellt werden kann, bevorzugt in einem Bereich von 0,01 mm bis 3 mm, besonders bevorzugt in einem Beriech von 0,02 mm bis 2 mm, besonders bevorzugt in einem Beriech von 0,025 mm bis 1,5 mm.

5. Anlage (1) nach einem der vorangegangenen Ansprüche,
**dadurch gekennzeichnet, dass**
die Haltevorrichtung (2) die Trägerplatte (7) mit Hilfe einer Verfahreinrichtung (2.5) in vertikaler und/oder horizontaler Richtung bewegen und in einer definierten Lage halten kann.

6. Verfahren zur Herstellung von Druckformen für Flexo Druck, bei dem eine Trägerplatte (7) an einer Haltevorrichtung (2) in ein mit einem verfestigbaren Medium (5) befüllbares Becken (3) eingetaucht und zumindest partiell in frei wählbaren Bereichen mittels einer Belichtungsanlage (8) mit UV-Licht bestrahl wird, die folgenden Schritte umfassend:
a (100) Eintauchen der Trägerplatte (7) an der Haltevorrichtung (2) in das Becken (3) mit verfestigbarem Medium (5);
b (200) Einstellen der Dicke einer Schicht (4) des verfestigbaren Mediums (5) zwischen Trägerplatte (7) und Belichtungsanlage (6) durch eine Relativbewegung von Trägerplatte (7) und Becken (3);
c (300) Belichten von frei wählbaren Bereichen des verfestigbaren Mediums (5) der Schicht (4) zwischen Trägerplatte (7) und Belichtungsanlage (8) zur Verfestigung des verfestigbaren Mediums (5) mittels UV-Licht der Belichtungsanlage (8);
d (400) Wiederholung der Schritte b und c zur Herstellung von Schichten aus verfestigtem Medium (4) zu einer verfestigten und erhabenen Struktur (6) aus dem verfestigbaren Medium (5) auf der Trägerplatte (7).
e (500) Herausfahren der Trägerplatte (7) mit der hergestellten erhabenen Struktur (6) aus Schichten von verfestigtem Medium (4) durch eine Relativbewegung von Becken (3) und Trägerplatte (7).

7. Verfahren nach Anspruch 6, mit den weiterführenden Schritten
f (600) Bestrahlung der hergestellten erhabenen Struktur (6) mit UV-A und/oder UV-C Strahlung;
g (700) Trennen der hergestellten erhabenen und schichtweise verfestigten Struktur von der Trägerplatte (7),
wobei der Schritt f auch nach dem Schritt g erfolgen kann.

8. Verfahren nach Anspruch 6 oder 7
**dadurch gekennzeichnet, dass**
das verfestigbare Medium (5) im Verfahrensschritten c oder in den Verfahrensschritten c und f durch UV-A-Strahlung in einem Wellenlängenbereich von 300 nm bis 410 nm, bevorzugt 320 nm bis 400 nm, besonders bevorzugt 340 nm bis 380 nm, verfestigt wird.

9. Verfahren nach Anspruch 7,
**dadurch gekennzeichnet, dass**
das verfestigbare Medium (5) im Verfahrensschritt f durch UV-C Strahlung in einem Wellenlängenbereich von 90 nm bis 300 nm, bevorzugt 100 nm bis 280 nm, besonders bevorzugt 150 bis 240 nm, weiter verfestigt und die Oberfläche entklebt wird, wobei die erhabene Struktur nach der Einwirkung von UV-Strahlung noch flexibel ist.

10. Verfahren nach einem der Ansprüche 6 bis 9,
**dadurch gekennzeichnet, dass**
der Aufbau von Schichten (4) auf einem flexiblen Grundmaterial erfolgt, welches an der Trägerplatte (7) angeordnet ist und/oder das Grundmaterial, auf dem die Schichten (4) von verfestigbarem Medium (5) aufgebracht werden, eine flexible Stützstruktur aufweist.
